# FASCICULE DE BREVET EUROPEEN

(11) **EP 2 729 940 B1**
(45) Date de publication et mention de la délivrance du brevet: **28.02.2018**
(21) Numéro de dépôt: 12735265.6
(22) Date de dépôt: 05.07.2012
(51) Int. Cl.: H01B 3/56, H01H 33/56, H02B 13/055, H05K 5/06

(54) **UTILISATION D'UN MELANGE COMPRENANT UNE HYDROFLUOROOLEFINE COMME GAZ D'ISOLATION ET/OU D'EXTINCTION D'ARC EN MOYENNE TENSION ET APPAREIL ELECTRIQUE MOYENNE TENSION LE COMPRENANT**
VERWENDUNG EINER MISCHUNG MIT EINEM HYDROFLUOROLEFIN ALS MITTELSPANNUNGSLICHTBOGENLÖSCHENDES UND/ODER ISOLIERENDES GAS UND MITTELSPANNUNGSELEKTROGERÄT DAMIT
USE OF A MIXTURE COMPRISING A HYDROFLUOROOLEFIN AS A MEDIUM-VOLTAGE ARC-EXTINGUISHING AND/OR INSULATING GAS AND MEDIUM-VOLTAGE ELECTRICAL DEVICE COMPRISING SAME

(30) Priorité: 05.07.2011 FR 1156062
(43) Date de publication de la demande: 14.05.2014
(73) Titulaire: Schneider Electric Industries SAS, 92500 Rueil-Malmaison (FR)
(72) Inventeur: KIEFFEL, Yannick, 38440 Saint Jean De Bournay (FR); GIRODET, Alain, 69680 Chassieu (FR); PICCOZ, Daniel, 69480 Lucenay (FR); MALADEN, Romain, 38050 Grenoble Cedex 9 (FR)
(74) Mandataire: Ahner, Philippe
(86) Numéro de dépôt international: PCT/EP2012/063180
(87) Numéro de publication internationale: WO 2013/004796

(56) Documents cités:
- WO-A1-2005/108523
- US-A1- 2008 135 817
- US-A1- 2010 123 095

## Description

### DOMAINE TECHNIQUE

La présente invention se rapporte au domaine de l'isolation électrique et de l'extinction des arcs électriques dans des appareils moyenne tension.

Plus précisément, elle se rapporte à l'utilisation de mélanges qui comprennent un alcène particulier, à savoir une hydrofluorooléfine à trois atomes de carbone, en tant que gaz d'isolation et/ou d'extinction d'arc dans des appareils électriques de sous-station et, en particulier, dans des appareils moyenne tension. L'hydrofluorooléfine peut être utilisée en mélange avec une autre hydrofluorooléfine ou avec un gaz de dilution dont le potentiel de réchauffement global est inférieur au sien, notamment inférieur ou égal à un.

Elle se rapporte également à des appareils électriques de sous-station de moyenne tension dans lesquels l'isolation électrique et/ou l'extinction d'arc électrique sont assurées par un milieu gazeux comprenant au moins une hydrofluorooléfine, ce composé présentant le plus fort potentiel de réchauffement global des gaz présents dans le milieu gazeux.

Un tel appareil électrique peut notamment être un transformateur électrique tel qu'un transformateur d'alimentation ou de mesure, une ligne à isolation gazeuse pour le transport ou la distribution de l'électricité, un jeu de barres ou encore un appareil électrique de connexion/déconnexion (aussi appelé appareil de coupure) tel qu'un disjoncteur, un interrupteur, un combiné interrupteur-fusibles, un sectionneur, un sectionneur de mise à la terre ou un contacteur.

### ÉTAT DE LA TECHNIQUE ANTÉRIEURE

Dans ce qui précède et ce qui suit, les termes « moyenne tension » (MT) et « haute tension » (HT) sont utilisés dans leur acceptation habituelle, à savoir que le terme « moyenne tension » désigne une tension qui est supérieure à 1000 volts en courant alternatif et à 1500 volts en courant continu mais qui ne dépasse pas 52 000 volts en courant alternatif et 75 000 volts en courant continu, tandis que le terme « haute tension » désigne une tension qui est strictement supérieure à 52 000 volts en courant alternatif et à 75 000 volts en courant continu.

Dans les appareils électriques moyenne ou haute tension, l'isolation électrique et, le cas échéant, l'extinction des arcs électriques sont typiquement assurées par un gaz qui est confiné à l'intérieur d'une enceinte de ces appareils. Actuellement, le gaz le plus souvent utilisé est l'hexafluorure de soufre (SF₆) : ce gaz présente une rigidité diélectrique relativement haute, une bonne conductivité thermique et des pertes diélectriques peu élevées. Il est chimiquement inerte et non toxique pour l'homme et les animaux et, après avoir été dissocié par un arc électrique, il se recombine rapidement et presque totalement. De plus, il est ininflammable et son prix est, encore aujourd'hui, modéré.

Toutefois, le SF₆ a pour inconvénient majeur de présenter un potentiel de réchauffement global (PRG) de 22 800 (relativement au CO₂ sur 100 ans) et une durée de séjour dans l'atmosphère de 3 200 ans, ce qui le place parmi les gaz à fort pouvoir d'effet de serre. Le SF₆ a donc été inscrit par le Protocole de Kyoto (1997) sur la liste des gaz dont les émissions doivent être limitées.

Le meilleur moyen de limiter les émissions du SF₆ consiste à limiter l'utilisation de ce gaz, ce qui a conduit les industriels à chercher des alternatives au SF₆. De fait, les autres solutions comme les systèmes hybrides associant une isolation gazeuse à une isolation solide (EP-A-1724 802) augmentent le volume des appareils électriques par rapport à celui qu'autorise une isolation au SF₆ ; la coupure dans l'huile ou le vide nécessite une refonte des appareillages.

Des gaz diélectriques sont connus : voir par exemple WO-A-2008/073790. Cependant, les gaz dits simples comme l'air ou l'azote, qui n'ont pas d'impact négatif sur l'environnement, présentent une rigidité diélectrique beaucoup plus faible que celle du SF₆ ; leur utilisation pour l'isolation électrique et/ou l'extinction des arcs électriques dans des appareils HT/MT implique d'augmenter de façon drastique le volume et/ou la pression de remplissage de ces appareils, ce qui va à l'encontre des efforts qui ont été réalisés au cours de ces dernières décennies pour développer des appareils électriques compacts, à encombrement de plus en plus réduit.

Les perfluorocarbones (CₙF₂ₙ₊₂, c-C₄F₈) présentent, d'une manière générale, des propriétés de tenue diélectrique intéressantes, mais leur PRG s'inscrit typiquement dans une gamme allant de 5 000 à 10 000. D'autres alternatives prometteuses d'un point de vue caractéristiques électriques et PRG, comme le trifluoroiodométhane (CF₃I), sont classées parmi les substances cancérigènes, mutagènes et reprotoxiques de catégorie 3, ce qui est rédhibitoire pour une utilisation à une échelle industrielle.

Des mélanges de SF₆ et d'autres gaz comme l'azote ou le dioxyde d'azote sont utilisés pour limiter l'impact du SF₆ sur l'environnement : voir par exemple WO-A-2009/049144. Néanmoins, du fait du fort PRG du SF₆, le PRG de ces mélanges reste très élevé. Ainsi, par exemple, un mélange de SF₆ et d'azote dans un rapport volumique de 10/90 présente une rigidité diélectrique en tension alternative (50 Hz) égale à 59 % de celle du SF₆ mais son PRG est de l'ordre de 8 000 à 8 650. De tels mélanges ne sauraient donc être utilisés comme gaz à faible impact environnemental.

Ainsi, seuls les mélanges à PRG important permettent une tenue diélectrique proche de celle du SF₆ à basse température ; tous les mélanges à faible PRG proposés dans l'art antérieur permettent d'atteindre au maximum 80 % des performances des appareils SF₆ pour les températures d'utilisation les plus basses mais, notamment, en augmentant la pression de gaz, en ajoutant des déflecteurs diélectriques, en revêtant certaines pièces de couches isolantes, ce qui nécessite une nouvelle conception des appareillages MT ou HT en prenant des distances d'isolation supérieures et en ajoutant éventuellement des artifices comme des écrans, déflecteurs ou gainages.

Aussi, les Inventeurs se sont-ils fixé pour but de trouver un gaz qui, tout en ayant de bonnes propriétés d'isolation électrique et d'extinction des arcs électriques, ait un impact sur l'environnement faible ou nul. Les recherches les ont mené à envisager une nouvelle famille de gaz qui puisse être utilisée dans les appareils électriques moyenne ou haute tension qui sont actuellement commercialisés, en lieu et place du SF₆ dont sont généralement remplis ces appareils, et ce sur toute leur gamme des températures d'utilisation, notamment à très basses températures.

### EXPOSÉ DE L'INVENTION

Ces buts et d'autres encore sont atteints par l'invention qui propose, en premier lieu, l'utilisation d'un mélange comprenant au moins une hydrofluorooléfine comme milieu gazeux d'isolation électrique et/ou d'extinction des arcs électriques dans un appareil moyenne tension.

Les hydrofluorooléfines utilisées sont des alcènes de chaîne carbonée à trois éléments carbone, et de préférence de type C₃H₂F₄, qui ne sont pas toxiques, pas corrosifs, pas explosifs, ont un potentiel de destruction de l'ozone ODP (« *Ozone Depletion Potential* » selon la terminologie anglosaxonne) de 0, un PRG inférieur à 20, voire même inférieur à 10, et sont dotés de propriétés diélectriques aptes à leur faire remplacer le SF₆ comme gaz d'isolation et/ou d'extinction d'arc dans les appareils électriques de sous-station de moyenne tension.

Conformément à l'invention, le mélange est tel que ses composants sont maintenus à l'état de gaz dans les conditions de température et de pression auxquelles il est destiné à être soumis une fois confiné dans l'appareil électrique. L'hydrofluorooléfine peut être utilisée en mélange avec au moins une autre hydrofluorooléfine de même forme. Toutefois, les hydrofluorooléfines seront le plus souvent utilisées en mélange avec au moins un autre gaz qui n'appartient pas à leur famille, si la température d'ébullition de cette (ces) hydrofluorooléfine(s) ne permet de garantir son (leur) maintien à l'état gazeux notamment.

Dans ce cas, selon l'invention, les autres gaz utilisés dans le mélange ont un potentiel de réchauffement global inférieur à celui des hydrofluorooléfines ; le gaz vecteur, ou gaz de dilution, ou gaz tampon, présente de préférence une température d'ébullition très basse, c'est-à-dire typiquement égale ou inférieure à -50°C à la pression standard, et une rigidité diélectrique qui est au moins égale à celle que présente l'azote ou le dioxyde de carbone. De préférence, l'hydrofluorooléfine est mélangée à un gaz de type azote, air, avantageusement air sec, oxygène, dioxyde de carbone, ou un mélange de ces gaz. Le PRG global du milieu gazeux est en rapport des pressions partielles de chacun de ses composants, et donc inférieur à 10 ou 20, et de préférence inférieur à 5.

Conformément à l'invention, l'hydrofluorooléfine est présente dans le mélange en un pourcentage molaire M_{HFO} qui est au moins égal à 95 % du pourcentage molaire M (c'est-à-dire au moins égal à 0,95 fois ce pourcentage molaire M) déterminé par la formule : M = (P_{HFO}/P_{mélange}) × 100, dans laquelle P_{mélange} représente la pression du mélange à 20°C dans l'appareil électrique et P_{HFO} représente la pression, exprimée dans la même unité, qui équivaut à 20°C à la pression de vapeur saturante que présente l'hydrofluorooléfine à la température minimale d'utilisation de l'appareil électrique. De fait, P_{HFO} est déterminée par P_{HFO} = (PVS_{HFO} × 293)/Tₘᵢₙ, avec PVS_{HFO} représentant la pression de vapeur saturante de l'hydrofluorooléfine à la température minimale Tₘᵢₙ, exprimée en kelvins, d'utilisation de l'appareil électrique. Ainsi, les propriétés diélectriques du mélange sont les plus élevées possibles et se rapprochent au mieux de celles du SF₆. Dans les modes de réalisation préférés, la température minimale d'utilisation Tₘᵢₙ est choisie parmi : 0, -5, -10, -15, -20, -25, -30, -35, -40, -45 et -50°C.

Dans le cas où l'appareil électrique est un appareil moyenne tension, la présence partielle de milieu à l'état liquide n'est pas de nature à poser de problème normatif. Il est donc possible d'utiliser un mélange dans lequel l'hydrofluorooléfine est présente en un pourcentage molaire M_{HFO} supérieur au pourcentage molaire M. De préférence, le pourcentage molaire de l'hydrofluorooléfine M_{HFO} est compris entre 95 % et 130 %, mieux encore entre 95% et 120 %, et idéalement entre 99 % et 110 % du pourcentage molaire M. Autrement dit, l'hydrofluorooléfine est préférentiellement présente dans le mélange en un pourcentage molaire qui est compris entre 0,95 fois et 1,3 fois, mieux encore, entre 0,95 fois et 1,2 fois, et idéalement entre 0,99 et 1,1 fois le pourcentage molaire M.

Dans le cas où l'appareil électrique est un appareil moyenne ou haute tension, du type poste sous enveloppe métallique, il est souhaitable, pour qu'il puisse répondre aux normes CEI actuellement en vigueur, que le mélange soit exclusivement ou quasi exclusivement à l'état gazeux dans toute la gamme des températures d'utilisation de cet appareil. Il est donc préféré que l'hydrofluorooléfine soit présente en un pourcentage molaire M_{HFO} qui ne dépasse pas 100 % du pourcentage molaire M (c'est-à-dire qui ne dépasse pas 1 fois ce pourcentage molaire M) afin de ne pas présenter de phase de liquéfaction. De préférence, le pourcentage molaire de l'hydrofluorooléfine M_{HFO} est compris entre 98% et 100 % du pourcentage molaire M (c'est-à-dire entre 0,98 fois et 1 fois ce pourcentage molaire M).

L'invention a également pour objet un appareil électrique de moyenne tension, qui comprend une enceinte étanche dans laquelle se trouvent des composants électriques ainsi qu'un milieu gazeux assurant l'isolation électrique et/ou l'extinction d'arc électrique au sein de cette enveloppe, ce milieu gazeux étant constitué par un mélange comprenant au moins une hydrofluorooléfine. Les caractéristiques du mélange sont telles que précédemment décrites à propos de son utilisation.

Conformément à l'invention, cet appareil électrique peut être un transformateur électrique à isolation gazeuse comme, par exemple, un transformateur d'alimentation ou un transformateur de mesure. L'appareil électrique peut également être une ligne à isolation gazeuse, aérienne ou souterraine, ou un jeu de barres pour le transport ou la distribution de l'électricité. Enfin, il peut aussi être un appareil électrique de connexion/déconnexion (aussi appelé appareil de coupure) comme, par exemple, un disjoncteur, un interrupteur, un sectionneur, un combiné interrupteur-fusibles, un sectionneur de mise à la terre ou un contacteur.

### BRÈVE DESCRIPTION DES DESSINS

D'autres avantages et caractéristiques ressortiront plus clairement de la description qui suit de modes particuliers de réalisation de l'invention, donnés à titre illustratif et nullement limitatifs, représentés dans les figures annexées.
La figure 1 représente la pression de vapeur saturante de deux HFO selon la température.
La figure 2 illustre, sous la forme d'une courbe, l'évolution de la rigidité diélectrique normalisée d'un mélange de HFO-1234ze et de N₂ en fonction du pourcentage molaire de HFO que présente ce mélange.
La figure 3 montre un dispositif dans lequel les tests de tenue diélectrique ont été réalisés avec un mélange selon l'invention.
La figure 4 illustre, sous la forme sous la forme d'un diagramme en barres, l'évolution de la tenue diélectrique d'un mélange de HFO-1234ze et de N₂ en fonction du pourcentage molaire de HFO-1234ze que présente ce mélange.

### EXPOSÉ DÉTAILLÉ DE MODES DE RÉALISATION PARTICULIERS

L'invention est basée sur l'utilisation, avec ou sans gaz de dilution (gaz « tampon » comme N₂, CO₂, air, ...), des hydrofluorooléfines (HFO) à au moins trois atomes de carbone ; les HFO sont des alcènes substitués par le fluor, de formule générale Cₙ(H,F)₂ₙ. En particulier, les HFO utilisées comprennent 3 atomes de carbone ; elles sont ininflammables et leur PRG est inférieur à 10.

Notamment l'hydrofluorooléfine HFO-1234ze, ou *trans-*1,3,3,3-tétrafluoro-1-propène, qui répond à la formule CHF=CH-CF₃, est utilisée pour les exemples comparatifs suivants. Son impact environnemental est PRG = 6, et elle ne présente pas de toxicité pour l'homme avec une valeur moyenne d'exposition (teneur limite moyenne à laquelle la majorité des travailleurs peut être exposée régulièrement à raison de 8 heures de travail pendant 5 jours par semaine, sans subir d'effet nocif) de VME = 1 000 ppm, et une dose létale DL50 causant la mort de 50 % d'une population animale supérieure à 200 000 ppm. Or, dans la plupart des applications classiques à très basse température (-30°C, voire -40°C), la HFO est diluée, parfois à moins de 20 %, dans un gaz vecteur neutre de type azote : le mélange n'est donc pas toxique.

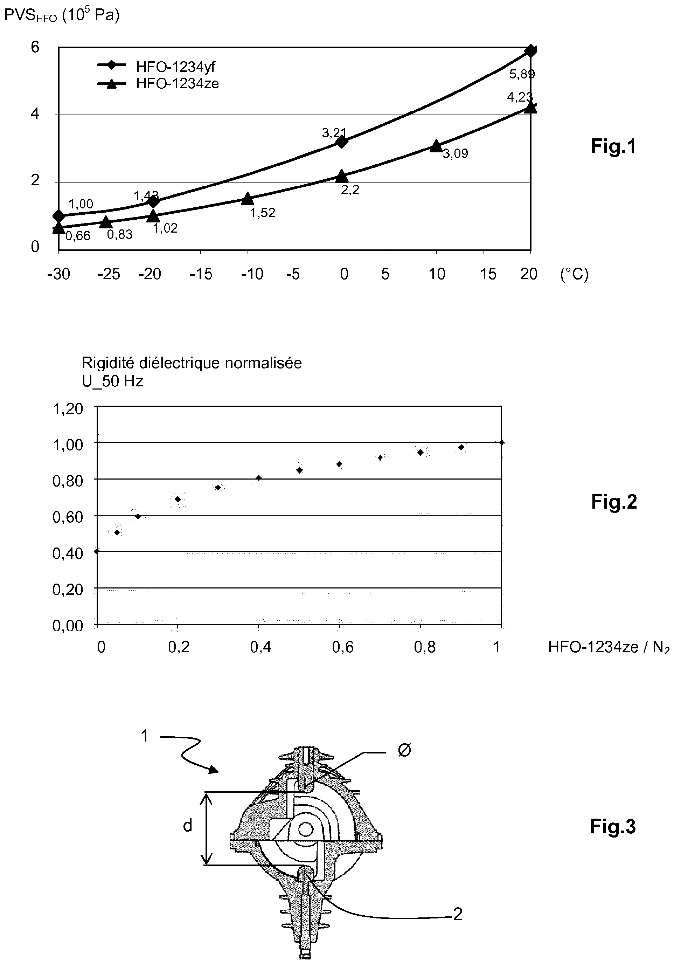

Selon un mode de réalisation préféré de l'invention, la HFO est utilisée sous forme gazeuse quelle que soit la température d'utilisation de l'appareillage électrique. Il convient donc que sa pression partielle soit inférieure ou égale à sa pression de vapeur saturante (PVS) à la plus basse température. Cependant, comme le remplissage des appareillages est usuellement fait à température ambiante, on utilise une pression équivalente P_{HFO}, par exemple à 20°C pour obtenir un résultat conforme aux préconisations selon l'invention. Le tableau I donne ainsi les valeurs de pression de HFO-1234ze en fonction de la température (voir aussi figure 1).

**Tableau I : Pressions de vapeur saturante de HFO-1234ze.**

| **Température** (°C) | **PVS estimée** (kPa) | **P_{HFO} à 20°C** (kPa) |
|---|---|---|
| 0°C | 220 | 236 |
| -10°C | 150 | 167 |
| -20°C | 100 | 116 |
| -25°C | 83 | 98 |
| -30°C | 66 | 80 |
| -40°C | 41 | 52 |

Selon l'appareillage, la pression interne du milieu d'isolation et/ou d'extinction d'arc qui est préconisée varie. Comme la HFO est, selon l'invention, entièrement ou quasi-entièrement sous forme gazeuse à la température la plus basse de l'appareil électrique, pour remplir les conditions de pressions de remplissage données, un gaz de dilution, ou gaz tampon, est ajouté. Notamment, pour un appareil de type qui doit être rempli à 5 bars (soit 500 kPa), si une utilisation à -20°C est envisagée, 1,16 bar (soit 116 kPa) de HFO-1234ze est mélangé à 3,84 bars (soit 384 kPa) de gaz tampon à température ambiante.

De préférence, le gaz de dilution présente une température d'ébullition très basse, inférieure ou égale à la température minimale Tₘᵢₙ d'utilisation de l'appareil, et une rigidité diélectrique supérieure ou égale à celle du CO₂ ou de l'air dans des conditions d'essai identiques (même appareillage, même configuration géométrique, mêmes paramètres opératoires, ...) à celles utilisées pour mesurer la rigidité diélectrique dudit gaz. Par ailleurs, selon l'invention, le gaz de dilution utilisé est un gaz à faible PRG de type air ou CO₂ : ainsi, le milieu gazeux utilisé comme isolant et extincteur d'arc dans les appareils électriques a un PRG inférieur ou égal à celui de la HFO de référence. De préférence, un gaz de dilution de PRG nul, l'azote N₂, est utilisé.

Afin de déterminer la composition du mélange au remplissage, on détermine donc la pression de remplissage de l'appareil électrique P_{mélange}. Le pourcentage molaire M équivalent en HFO est donné par la formule M = (P_{HFO/}P_{mélange}) × 100, avec P_{HFO} pression équivalente à la température concernée (c'est-à-dire en général la température de remplissage, correspondant à la pression de remplissage) de la pression de vapeur saturante PVS de HFO à la température minimale d'utilisation Tₘᵢₙ de l'appareil (P_{HFO} = (PVS_{HFO} × 293)/Tₘᵢₙ). Ce pourcentage M représente la quantité maximale de HFO pour qu'il n'y ait pas de liquide dans l'enceinte. Dans certains cas, il est impératif de ne pas dépasser ce seuil M pour éviter toute présence de liquide ; parfois, par exemple en moyenne tension, il est possible d'avoir un peu de liquide à basse ou très basse température, et le pourcentage molaire M_{HFO} de remplissage peut atteindre 110 % voire 130 % de M. Par ailleurs, comme la HFO possède une meilleure tenue diélectrique que les gaz vecteurs, il est souhaitable d'optimiser le remplissage par la HFO : on choisit donc M_{HFO} supérieur ou égal à 95 % du pourcentage molaire M, de préférence M_{HFO} ≥ 0,98·M, ou M_{HFO} = 0,99·M.

De fait, la rigidité diélectrique de la HFO pure est proche de celle du SF₆ pur, meilleure que celle des gaz de dilution. Tel qu'illustré en figure 2, la mesure sur un appareil de type GIS 145 kV en tension alternative 50 Hz de la HFO-1234ze, seule ou en mélange avec de l'azote, montre que le mélange selon l'invention remplit les conditions d'utilisation des appareillages actuels.

En particulier, la tenue diélectrique de la HFO, seule ou en mélange avec un gaz de dilution « neutre », s'est avérée remplir les conditions requises. Notamment :
- sur ligne directe, les essais sous choc de foudre (onde de 1,2 - 50 µs) entre phase et terre ont été réalisés à l'intérieur d'une enceinte 1 époxy (de type Fluokit M24+, c'est-à-dire de type « *air insulated switchgear* », ou à isolation dans l'air) entre deux contacts 2 de rayon 12 mm en cuivre argenté distants de d = 134 mm illustrée en figure 3, à température ambiante. Les résultats sont donnés en tableau II : dans une configuration de champ électrique non homogène, la HFO-1234ze a une tenue diélectrique équivalente à celle du SF₆.
- en cheminement, les essais sous choc de foudre (onde de 1,2 - 50 µs) ont été réalisés à l'intérieur de la même enceinte illustrée en figure 3 dans laquelle la distance de séparation des contacts est de d = 317 mm, à température ambiante. Le champ électrique moyen (Ucrête / 317 mm) ayant entrainé l'amorçage entre les contacts 2 par cheminement est de 814 V/mm, valeur qui est seulement 10 % inférieure à celle mesurée dans les mêmes conditions avec un appareil rempli de SF₆ à la même pression.

De même, dans une configuration de champ électrique non homogène, tel que présenté dans le tableau III, la HFO-1234ze a une tenue aux décharges partielles équivalente à celle du SF₆; les essais comparatifs de tenue aux décharges partielles (effet Corona) ont été réalisés dans la même enceinte que ceux de tenue diélectrique sur ligne directe (figure 3, d = 134 mm).

**Tableau II : tenue diélectrique de HFO-1234ze seule ou en mélange**

| **Gaz** | **Pression absolue** | **Tenue en polarité positive** | **Tenue en polarité négative** |
|---|---|---|---|
| SF₆ | 300 kPa | 190 kV | 185 kV |
| HFO-1234ze | 300 kPa | 183 kV | 208 kV |
| Différence / SF₆ | | - 3,6 % | +12,4% |
| N₂ | 130 kPa | 118 kV | 113 kV |
| HFO-1234ze + N₂ | 30 kPa + 100 kPa (mélange grand froid -45°C) | 254 kV | 285 kV |
| Différence / N₂ | | + 215 % | + 252 % |

**Tableau III : tenue aux décharges partielles de HFO-1234ze seule ou en mélange**

| **Gaz** | **Pression absolue** | **Seuil d'extinction** |
|---|---|---|
| SF₆ | 200 kPa | 20 kV |
| HFO-1234ze | 200 kPa | 26 kV |
| Différence / SF₆ | | + 6 kV |
| SF₆ | 120 kPa | 65 kV |
| HFO-1234ze + N₂ | 20 kPa + 100 kPa (mélange grand froid -50°C) | 57 kV |
| Différence / SF₆ | | - 8 kV |

Un essai comparatif de tenue à l'échauffement, mené sur un appareil type AIS mesure, au niveau des contacts électriques (points les plus chauds), les échauffements maximum sur l'appareil traversé par un courant permanent de 630 A RMS. Tel que présenté dans le tableau IV, les échauffements mesurés sur une moyenne de trois points de mesure avec la HFO-1234ze sont du même ordre de grandeur que ceux mesurés avec le SF₆.

**Tableau IV : tenue à l'échauffement de la HFO seule ou en mélange**

| **Gaz** | **Echauffement des contacts** | |
|---|---|---|
| (en pression absolue) | température absolue | par rapport à SF₆ |
| SF₆ (138 kPa) | 50,63 K | / |
| N₂ (138 kPa) | 53,6 K | +5,8% |
| HFO-1234ze (138 kPa) | 50,13 K | -1% |
| HFO-1234ze (98 kPa) + N₂ (40 kPa) (mélange grand froid -25°C) | 50,8 K | +0,3% |

Par exemple, on utilisera l'hydrofluorooléfine HFO-1234ze avec un peu d'azote dans les appareils grand froid (Tₘᵢₙ ≤ -40°C), la quantité d'additif étant clairement établie en fonction de la température minimale d'utilisation de l'appareillage électrique.

Plus généralement, le taux de la HFO-1234ze étant lié à sa pression de vapeur saturante, il est possible de déterminer la rigidité diélectrique à 50 Hz (U_50 Hz) de différents mélanges HFO-1234ze / N₂ (à différents taux de HFO) correspondant à différentes températures minimales de -30°C à 0°C : voir tableau V, qui donne en outre une comparaison avec les propriétés du SF₆ permettant de vérifier que les conditions d'utilisation sont remplies. Par exemple, pour un appareillage destiné à être utilisé à une température minimale de -30°C où la pression de vapeur saturante de la HFO-1234ze est de 66 kPa, ce qui représente une pression de 80 kPa mesurée à 20°C, et si la pression totale dans ce type d'appareil du mélange gazeux est de 5 bars absolus (soit 500·kPa), le ratio molaire sera alors de 0,8/5, soit 16 % de la HFO dans de l'azote. Le PRG du mélange est de l'ordre de 2 : en effet, un mélange à 16 % molaire de HFO-1234ze de PRG = 6 avec de l'azote diminue fortement l'impact environnemental.

**Tableau V : caractéristiques d'un mélange HFO-1234ze / N₂**

| **Température** (°C) | **PVS HFO-1234ze** (kPa abs) | **Pression totale** (kPa) | **Ratio HFO-1234ze** (%) | **U_50 Hz** (kV rms) | **% SF₆** |
|---|---|---|---|---|---|
| -30 | 66 | 500 | 15,9 | 296 | 65 |
| -25 | 83 | 500 | 19,6 | 312 | 69 |
| -20 | 102 | 500 | 23,6 | 327 | 72 |
| -10 | 152 | 500 | 33,9 | 354 | 78 |
| 0 | 220 | 500 | 47,2 | 379 | 84 |

Au vu des performances de la HFO, seule ou en mélange avec un gaz de dilution simple de type air ou azote, une utilisation dans un appareillage existant peut être envisagée. En particulier, après avoir fait le vide à l'aide d'une pompe à vide à huile, on peut remplir un appareil commercial de 5 bars pour une utilisation à -30°C à l'aide d'un mélangeur de gaz permettant de contrôler le rapport entre la HFO-1234ze et le gaz vecteur N₂, ce rapport étant maintenu constant et égal à 16 % en pression tout au long du remplissage grâce à l'utilisation de débitmètre massique de précision ; de préférence, le vide (0 à 0,1 kPa) a été fait auparavant dans l'appareil.

Par exemple, il peut s'agir d'un appareil de type GIS de 145 kV de tension assignée et qui a une structure strictement identique à celle que présente l'appareil qui est commercialisé par Alstom Grid sous la référence B65 et rempli actuellement de SF₆. L'appareil ainsi rempli du mélange proposé est ensuite soumis à des essais de tenue diélectrique à température ambiante, sous chocs de foudre (onde de 1,2 - 50 µs) à onde positive et à onde négative conformément à la norme CEI 62271-1, tel que décrit plus haut. La rigidité diélectrique sous fréquence industrielle atteint la valeur de 296 kV rms, ce qui représente 65 % de la tenue diélectrique de cet appareil sous SF₆ à même pression et au moins 68 % de plus que la tenue diélectrique du même appareil rempli d'air sec ou d'azote à même pression. Les performances sont donc tout à fait convenables, et bien supérieures à celles obtenues pour d'autres gaz d'isolation à PRG faible.

Pareillement, il peut s'agir d'un appareil moyenne tension comme le Fluokit M24+ commercialisé par Schneider Electric : en remplissant cet interrupteur sectionneur de type AIS d'un mélange HFO-1234ze (98 kPa absolu) et N₂ (40 kPa absolu), on peut réaliser des essais de coupure dans les conditions fixées par la norme CEI 60265-1 cycle TD1, et ainsi estimer les performances de la HFO-1234ze en coupure, en les comparant avec celles du SF₆. L'appareil a ainsi coupé 630 A/12 kV avec des temps d'arcs similaires à ceux mesurés avec le SF₆; en augmentant progressivement tension et courant jusqu'à la non coupure, on a pu constater des limites préliminaires (sans aucune précaution et/ou adaptation du fait de ce nouveau mélange) de l'appareil à 811 A/16 kV, *a priori* légèrement supérieures à celles obtenues avec du SF₆.

Il est à noter par ailleurs que, les appareils actuels étant déjà équipés de tamis moléculaire de type sulfate de calcium (CaSO₄) anhydre qui adsorbent les petites molécules créées lors de la coupure, la toxicité du gaz n'est pas augmentée après décharges partielles par des molécules pouvant présenter une toxicité.

De plus, en fin de vie ou après essais de coupure, le gaz est récupéré par les techniques classiques de récupération utilisant un compresseur et une pompe à vide. L'hydrofluorooléfine HFO-1234ze est alors séparée du gaz tampon en utilisant une zéolithe capable de piéger uniquement le gaz tampon, de taille inférieure ; alternativement, une membrane à séparation sélective laisse s'échapper l'azote et garde la HFO-1234ze qui a une masse molaire plus importante ; toute autre option est envisageable.

L'influence du pourcentage molaire de l'hydrofluorooléfine dans le mélange sur la tenue diélectrique de ce mélange a été vérifiée par des essais complémentaires de tenue diélectrique, en champ homogène, que l'on a réalisés, à température ambiante, sur une série d'appareils de moyenne tension du type Fluokit M24+.

Ces appareils ont été remplis soit avec des mélanges HFO-1234ze / azote en faisant varier, d'un appareil à l'autre, le pourcentage molaire de l'HFO-1234ze de sorte qu'il soit respectivement égal à 53%, 81%, 100 % et 120 % du pourcentage molaire M d'HFO-1234ze qui permet de garantir qu'à -25°C la proportion d'HFO-1234ze se trouvant à l'état gazeux est maximale, soit avec de l'HFO-1234 pure.

Les résultats de ces essais sont présentés dans le tableau VI ci-après, dans lequel la tenue diélectrique obtenue avec un mélange HFO-1234ze / azote ou avec HFO-1234 pure est exprimée sous la forme d'un pourcentage de la tenue diélectrique obtenue à la même température et pour le même type d'appareil lorsque celui-ci est rempli de SF₆ à la même pression totale.

**Tableau VI : Influence du pourcentage molaire d'HFO-1234ze sur la tenue diélectrique**

| **Pression totale à 20°C** (kPa) | **Pression de HFO-1234ze à 20°C** (kPa) | **Pourcentage molaire de HFO-1234ze** | **Tenue diélectrique** (en % de celle obtenue avec SF₆) |
|---|---|---|---|
| 130 | 51,6 | 39,7 (soit 53 % de M) | 57 |
| 130 | 79,6 | 61,2 (soit 81 % de M) | 68 |
| 130 | 98,1 | 75,5 (soit 100 % de M) | 79 |
| 130 | 118,1 | 90,8 (soit 120 % de M) | 89 |
| 130 | 130 | 100 (soit 133 % de M) | 98 |
| 142 | 142 | 100 (soit 146 % de M) | 106 |

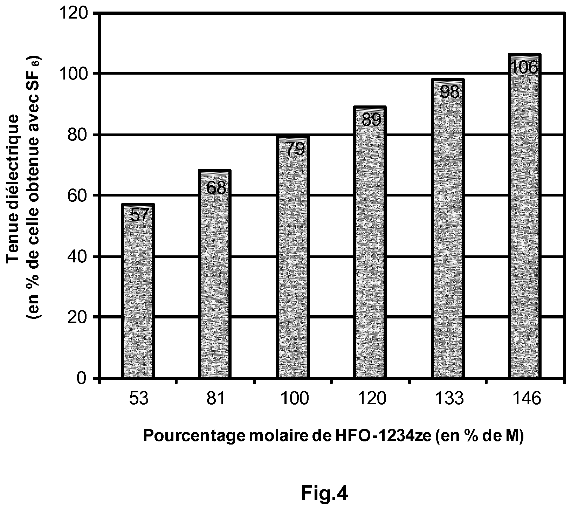

Les résultats de ces essais sont également illustrés, sous la forme d'un diagramme en barres, sur la figure 4 dans laquelle sont indiqués :
- en abscisse, le pourcentage molaire de HFO-1234ze, exprimé en pourcentage du pourcentage molaire M ; et
- en ordonnée, la tenue diélectrique obtenue, exprimée en pourcentage de celle obtenue avec le SF₆.

Le tableau VI et la figure 4 confirment bien que, dès lors qu'une hydrofluorooléfine comme HFO-1234ze est utilisée en mélange avec un gaz vecteur tel que l'azote, il est souhaitable que cette hydrofluorooléfine soit présente dans ce mélange en un pourcentage molaire au moins égal à 95% du pourcentage molaire M si l'on veut se rapprocher des performances du SF₆ en terme de tenue diélectrique ou dépasser ces performances.

Bien que les exemples ci-dessus aient été réalisés avec la HFO-1234ze, les alternatives à ce gaz sont possibles. En particulier, l'isomère HFO-1234yf, ou 2,3,3,3-tétrafluoro-1-propène, qui répond à la formule CH₂=CF-CH₃, peut être utilisé, avec les adaptations inhérentes aux propriétés de ce gaz : en particulier, tel qu'illustré en figure 1, comme la température d'ébullition est de -30°C (contre -19°C pour la HFO-1234ze), il est possible pour la même température de fonctionnement de -30°C de mettre 50 % de plus de HFO-1234yf que de HFO-1234ze. Comme pour une pression de remplissage donnée, plus il y a de HFO, et par conséquent moins il y a de gaz tampon, et que les propriétés d'isolation et d'extinction d'arc dépendent du mélange, la rigidité diélectrique est augmentée.

La solution selon l'invention permet ainsi de proposer un gaz ou un mélange gazeux à faible impact environnemental (PRG diminué de plus de 99,9% par rapport à une isolation au SF₆) compatible avec les températures d'utilisation minimales de l'appareillage électrique et ayant des propriétés diélectrique, de coupure et de dissipation thermique proches de celles obtenues sur les appareils existants. Ce gaz, seul ou en mélange peut directement remplacer le SF₆ utilisé dans les appareils, sans modifier ou presque leur conception : les lignes de production peuvent être gardées, avec simple changement du gaz de remplissage.

### REFERENCES CITEES

EP-A-1 724 802
WO-A-2008/073790
WO-A-2009/049144

## Revendications

1. Utilisation d'un mélange comprenant une hydrofluorooléfine à trois atomes de carbone, ledit mélange ayant un potentiel de réchauffement global (PRG) inférieur au potentiel de réchauffement global de l'hydrofluorooléfine, comme milieu gazeux d'isolation électrique et/ou d'extinction d'arc électrique dans des appareils électriques de sous-station de moyenne tension,
dans laquelle l'hydrofluorooléfine est présente dans le mélange en un pourcentage molaire (M_{HFO}) au moins égal à 95 % du pourcentage molaire M déterminé par la formule M = (P_{HFO}/P_{mélange}) × 100, avec P_{mélange} la pression du mélange à 20°C dans l'appareil électrique et P_{HFO} la pression équivalente à 20°C à la pression de vapeur saturante (PVS) de l'hydrofluorooléfine à la température minimale (Tₘᵢₙ) d'utilisation de l'appareil électrique.

2. Utilisation d'un mélange selon la revendication 1, dans laquelle l'hydrofluorooléfine est le *trans*-1,3,3,3-tétrafluoro-1-propène (HFO-1234ze).

3. Utilisation d'un mélange selon la revendication 1, dans laquelle l'hydrofluorooléfine est le 2,3,3,3-tétrafluoro-1-propène (HFO-1234yf).

4. Utilisation selon l'une des revendications 1 à 3, dans laquelle le mélange comprend en outre un gaz de dilution.

5. Utilisation selon la revendication 4, dans laquelle le gaz de dilution est choisi parmi l'air, l'azote, l'oxygène, le dioxyde de carbone ou un mélange de ces gaz.

6. Utilisation selon la revendication 1, dans laquelle le pourcentage molaire d'hydrofluorooléfine (M_{HFO}) est compris entre 99% et 110 % du pourcentage molaire M.

7. Utilisation selon l'une des revendications 1 à 6, dans laquelle la température minimale (Tₘᵢₙ) est choisie parmi -50°C, -45°C, -40°C, -30°C, -25°C, -15°C, -10°C, -5°C, 0°C.

8. Appareil électrique moyenne tension, comprenant une enceinte étanche dans laquelle se trouvent des composants électriques ainsi qu'un milieu gazeux assurant l'isolation électrique et/ou l'extinction des arcs électriques susceptibles de se produire au sein de cette enceinte, **caractérisé en ce que** le milieu gazeux est constitué par un mélange qui comprend une hydrofluorooléfine à trois atomes de carbone, a un potentiel de réchauffement global (PRG) inférieur au potentiel de réchauffement global de l'hydrofluorooléfine, et **en ce que** l'hydrofluorooléfine est présente dans le mélange en un pourcentage molaire (M_{HFO}) au moins égal à 95 % du pourcentage molaire M déterminé par la formule : M = (P_{HFO}/P_{mélange}) × 100, avec P_{mélange} la pression du mélange à 20°C dans l'appareil électrique et P_{HFO} la pression équivalente à 20°C à la pression de vapeur saturante (PVS) de l'hydrofluorooléfine à la température minimale (Tₘᵢₙ) d'utilisation de l'appareil électrique.

9. Appareil électrique selon la revendication 8, dans lequel l'hydrofluorooléfine est le *trans*-1,3,3,3-tétrafluoro-1-propène (HFO-1234ze) ou le 2,3,3,3-tétrafluoro-1-propène (HFO-1234yf).

10. Appareil électrique selon l'une des revendications 8 ou 9, dans lequel le mélange comprend en outre un gaz de dilution.

11. Appareil électrique selon la revendication 10, dans lequel le gaz de dilution est choisi parmi l'air, l'azote, l'oxygène, le dioxyde de carbone ou un mélange de ces gaz.

12. Appareil électrique selon la revendication 8, dans lequel le pourcentage molaire d'hydrofluorooléfine (M_{HFO}) est compris entre 99% et 110% du pourcentage molaire M.

13. Appareil selon l'une quelconque des revendications 8 à 12, qui est un transformateur électrique à isolation gazeuse, une ligne à isolation gazeuse pour le transport ou la distribution de l'électricité ou un appareil électrique de connexion/déconnexion.

## Patentansprüche

1. Verwendung eines Gemischs mit einem Hydrofluorolefin mit drei Kohlenstoffatomen, wobei das Gemisch ein globales Erwärmungspotenzial (GWP) hat, das geringer ist als das globale Erwärmungspotenzial von Hydrofluorolefin, als gasförmiges Medium zur elektrischen Isolierung und/oder Löschung von Lichtbögen bei elektrischen Einrichtungen von Mittelspannungs-Umspannstationen,
wobei das Hydrofluorolefin in dem Gemisch mit einem Molprozentsatz (M_{HFO}) mindestens gleich 95 % des Molprozentsatzes M vorliegt, der mit der Formel M = (P_{HFO}/P_{Gemisch}) x 100 bestimmt wird, worin P_{Gemisch} der Druck des Gemischs bei 20°C in der elektrischen Einrichtung ist und P_{HFO} der Druck ist, der bei 20 °C äquivalent zum Sättigungsdampfdruck (PVS) von Hydrofluorolefin bei der Mindesttemperatur (Tₘᵢₙ) der Verwendung der elektrischen Einrichtung ist.

2. Verwendung eines Gemischs nach Anspruch 1, wobei das Hydrofluorolefin *trans*-1,3,3,3-Tetrafluor-1-propen (HFO-1234ze) ist.

3. Verwendung eines Gemischs nach Anspruch 1, wobei das Hydrofluorolefin 2,3,3,3-Tetrafluor-1-propen (HFO-1234yf) ist.

4. Verwendung nach einem der Ansprüche 1 bis 3, wobei das Gemisch ferner ein Verdünnungsgas enthält.

5. Verwendung nach Anspruch 4, wobei das Verdünnungsgas ausgewählt ist aus Luft, Stickstoff, Sauerstoff, Kohlendioxid oder einem Gemisch aus diesen Gasen.

6. Verwendung nach Anspruch 1, wobei der Molprozentsatz an Hydrofluorolefin (M_{HFO}) zwischen 99 % und 110 % des Molprozentsatzes M liegt.

7. Verwendung nach einem der Ansprüche 1 bis 6, wobei die Mindesttemperatur (Tₘᵢₙ) ausgewählt ist aus -50 °C, -45 °C, -40 °C, -30 °C, -25 °C, -15 °C, -10 °C, -5 °C, 0 °C.

8. Elektrische Mittelspannungseinrichtung, enthaltend ein dichtes Gehäuse, in welchem elektrische Komponenten sowie ein gasförmiges Medium vorhanden sind, das die elektrische Isolierung und/oder Löschung von Lichtbögen sicherstellt, die innerhalb dieses Gehäuses entstehen können,
**dadurch gekennzeichnet, dass**
das gasförmige Medium aus einem Gemisch besteht, das ein Hydrofluorolefin mit drei Kohlenstoffatomen enthält, das ein globales Erwärmungspotenzial (GWP) hat, das geringer ist als das globale Erwärmungspotenzial von Hydrofluorolefin, und
dass das Hydrofluorolefin in dem Gemisch mit einem Molprozentsatz (M_{HFO}) mindestens gleich 95 % des Molprozentsatzes M vorliegt, der mit der Formel M = (P_{HFO}/P_{Gemisch}) x 100 bestimmt wird, worin P_{Gemisch} der Druck des Gemischs bei 20°C in der elektrischen Einrichtung ist und P_{HFO} der Druck ist, der bei 20 °C äquivalent zum Sättigungsdampfdruck (PVS) von Hydrofluorolefin bei der Mindesttemperatur (Tₘᵢₙ) der Verwendung der elektrischen Einrichtung ist.

9. Elektrische Einrichtung nach Anspruch 8,
wobei das Hydrofluorolefin *trans*-1,3,3,3-Tetrafluor-1-propen (HFO-1234ze) oder 2,3,3,3-Tetrafluor-1-propen (HFO-1234yf) ist.

10. Elektrische Einrichtung nach einem der Ansprüche 8 oder 9,
wobei das Gemisch ferner ein Verdünnungsgas enthält.

11. Elektrische Einrichtung nach Anspruch 10,
wobei das Verdünnungsgas ausgewählt ist aus Luft, Stickstoff, Sauerstoff, Kohlendioxid oder einem Gemisch aus diesen Gasen.

12. Elektrische Einrichtung nach Anspruch 8, wobei der Molprozentsatz an Hydrofluorolefin (M_{HFO}) zwischen 99 % und 110 % des Molprozentsatzes M liegt.

13. Elektrische Einrichtung nach einem der Ansprüche 8 bis 12,
die ein gasisolierter, elektrischer Transformator, eine gasisolierte Leitung zum Übertragen bzw. Verteilen von Elektrizität oder eine elektrische An-/Abschalteinrichtung ist.

## Claims

1. Use of a mixture comprising a hydrofluoroolefin with three carbon atoms, said mixture having a global warming potential (GWP) lower than the global warming potential of the hydrofluoroolefin, as a gaseous medium for electrical insulation and/or electrical arc extinguishing in substation medium-voltage electrical devices,
in which the hydrofluoroolefin is present in the mixture at a molar percentage (M_{HFO}) at least equal to 95% of the molar percentage M determined by the formula M = (P_{HFO}/Pₘᵢₓₜᵤᵣₑ) × 100, in which Pₘᵢₓₜᵤᵣₑ is the pressure of the mixture at 20°C in the electrical device and P_{HFO} is the pressure that at 20°C is equivalent to the saturated vapour pressure (SVP) of the hydrofluoroolefin at the minimum service temperature (Tₘᵢₙ) of the electrical device.

2. Use of a mixture according to claim 1, in which the hydrofluoroolefin is *trans*-1,3,3,3-tetrafluoro-1-propene (HFO-1234ze).

3. Use of a mixture according to claim 1, in which the hydrofluoroolefin is 2,3,3,3-tetrafluoro-1-propene (HFO-1234yf).

4. Use according to one of claims 1 to 3, in which the mixture also comprises a dilution gas.

5. Use according to claim 4, in which the dilution gas is chosen from air, nitrogen, oxygen, carbon dioxide or a mixture of these gases.

6. Use according to claim 1, in which the hydrofluoroolefin molar percentage (M_{HFO}) is between 99% and 110% of the molar percentage M.

7. Use according to one of claims 1 to 6, in which the minimum temperature (Tₘᵢₙ) is chosen from -50°C, -45°C, -40°C, -30°C, -25°C, -15°C, -10°C, -5°C, 0°C.

8. Medium-voltage electrical device, comprising a sealed enclosure in which electrical components are located together with a gaseous medium providing electrical insulation and/or electric arc extinguishing within this enclosure, **characterised in that** the gaseous medium is composed of a mixture comprising a hydrofluoroolefin with three carbon atoms, has a global warming potential (GWP) lower than the global warming potential of the hydrofluoroolefin, and **in that** the hydrofluoroolefin is present in the mixture at a molar percentage (M_{HFO}) at least equal to 95% of the molar percentage M determined by the formula: M = (P_{HFO}/Pₘᵢₓₜᵤᵣₑ) × 100, in which Pₘᵢₓₜᵤᵣₑ is the pressure of the mixture at 20°C in the electrical device and P_{HFO} is the pressure that at 20°C is equivalent to the saturated vapour pressure (SVP) of the hydrofluoroolefin at the minimum service temperature (Tₘᵢₙ) of the electrical device.

9. Electrical device according to claim 8, in which the hydrofluoroolefin is *trans*-1,3,3,3-tetrafluoro-1-propene (HFO-1234ze) or 2,3,3,3-tetrafluoro-1-propene (HFO-1234yf).

10. Electrical device according to one of claims 8 and 9, in which the mixture also comprises a dilution gas.

11. Electrical device according to claim 10, in which the dilution gas is chosen from air, nitrogen, oxygen, carbon dioxide or a mixture of these gases.

12. Electrical device according to claim 8, in which the hydrofluoroolefin molar percentage (M_{HFO}) is between 99% and 110% of the molar percentage M.

13. Electrical device according to any one of claims 8 to 12, which is a gas-insulated electrical transformer, a gas-insulated line for transporting or distributing electricity or an electrical connection/disconnection device.
